Europäisches Patentamt

European Patent Office

Office européen des brevets

(11) Publication number: **0 335 724**
**A2**

## (12) EUROPEAN PATENT APPLICATION

(21) Application number: **89303169.0**

(22) Date of filing: **30.03.89**

(51) Int. Cl.⁴: **H 01 L 29/78**

(30) Priority: **31.03.88 JP 79199/88**

(43) Date of publication of application:
**04.10.89 Bulletin 89/40**

(84) Designated Contracting States: **DE FR GB IT**

(71) Applicant: **SEIKO INSTRUMENTS INC.**
**31-1, Kameido 6-chome Koto-ku**
**Tokyo 136 (JP)**

(72) Inventor: **Tanaka, Hideo**
**c/o SEIKO INSTRUMENTS INC. 31-1 Kameido 6-chome**
**Koto-ku Tokyo (JP)**

(74) Representative: **Caro, William Egerton et al**
**J. MILLER & CO. Lincoln House 296-302 High Holborn**
**London WC1V 7JH (GB)**

(54) Thin film transistor array for an electro-optical device and method of manufacturing the same.

(57) A thin film transistor array for an electro-optical device comprises a plurality of row electrodes, a plurality of column electrodes, and a plurality of picture element electrodes, each of the picture element electrodes and one of the row and column electrodes operating as source (2) or drain electrodes (1) and having a n-type semi-conductor layer (8) thereon and connecting to each other through a semi-conductor layer (9) provided on the n-type semi-conductor layer (8), the other of the row and column electrodes operating as gate electrodes (31, 32) provided on the semi-conductor layer (9) through an insulating layer (10). The gate electrodes and the corresponding source and drain electrodes constitute switching transistors, and the gate electrodes and neighbouring picture element electrodes having overlapping portions which operate as holding capacitors (4).

FIGURE I(A)

FIGURE I(B)

FIGURE I(C)

Description

# THIN FILM TRANSISTOR ARRAY FOR AN ELECTRO-OPTICAL DEVICE AND METHOD OF MANUFACTURING THE SAME

The present invention relates to thin film transistor (TFT) arrays for electro-optical devices, for example, liquid crystal panels and methods of manufacturing the same.

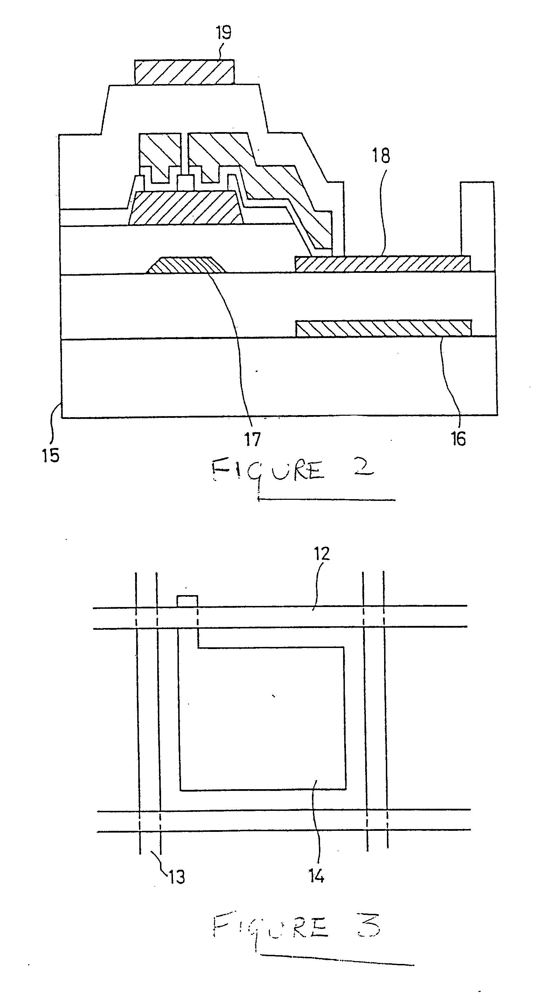

A known TFT with a complex construction and having a holding capacitor is shown in Figure 2. This TFT has an insulating substrate 15, a common electrode 16, a gate electrode 17, a picture element electrode 18 and a shading layer 19. The manufacture of the TFT of Figure 2, however, is cumbersome and manufacturing yield is, as a result, low.

A known TFT with a simpler construction but without a holding capacitor is shown in Figure 3. This TFT has a gate electrode 12, a drain electrode 13 and a source electrode 14. The TFT of Figure 3 can be manufactured using two photo-processing steps but because of its simplified construction it is not capable of holding a signal from a first writing operation to the next writing operation once a liquid crystal layer has been driven. This is because the TFT of Figure 3 does not have a holding capacitor.

The present invention seeks to provide a TFT array for an electro-optical device that has a simple construction and yet has a holding capacitor and that can be manufactured by only two photo-processing steps with good manufacturing yield.

According to one aspect of the present invention there is provided a thin film transistor array for an electro-optical device characterised by comprising a plurality of row electrodes, a plurality of column electrodes, and a plurality of picture element electrodes, each of the picture element electrodes and one of the row and column electrodes operating as source or drain electrodes and having a n-type semi-conductor layer thereon and connecting to each other through a semi-conductor layer provided on the n-type semi-conductor layer, the other of the row and column electrodes operating as gate electrodes provided on the semi-conductor layer through an insulating layer, the gate electrodes and the corresponding source and drain electrodes constituting switching transistors, and the gate electrodes and neighbouring picture element electrodes having overlapping portions which operate as holding capacitors.

The picture element electrodes and one of the column and row electrodes may be made of the same material e.g. indium-tin oxide.

The n-type semi-conductor layer may be is composed of hydrogenated amorphous silicon doped with phosphorus or fine crystalline silicon doped with phosphorus.

The semi-conductor layer may be composed of hydrogenated amorphous silicon or fluorinated amorphous silicon.

The insulating layer may be composed of nitrogenated amorphous silicon or oxidised amorphous silicon.

Preferably one terminal of the capacitor of the TFT is connected to the gate electrode of the preceding stage.

In the illustrated embodiment the holding capacitors are connected to the drain electrodes through narrow necks.

According to another aspect of the present invention there is provided a method of manufacturing a thin film transistor array for an electro-optical device characterised by comprising: successively depositing a transparent conductive film and an n-type semi-conductor layer on an insulating substrate; applying a photo-resist onto said n-type semi-conductor layer followed by the exposure and developing through a first photo-mask, and then selectively removing said n-type semi-conductor layer and said transparent conductive film; successively depositing a semi-conductor layer, an insulating film and a conductive film on said n-type semi-conductor layer and said insulating substrate; and applying a photo-resist onto said conductive film followed by exposure and developing through a second photo-mask, and then selectively removing said conductive film, said insulating film and said semi-conductor layer.

The invention is illustrated, merely by way of example, in the accompanying drawings, in which:-

Figure 1(A) is a plan view of a TFT of a TFT array according to the present invention;

Figure 1(B) is a sectional view of the TFT taken on the line X-X of Figure 1(A);

Figure 1(C) is a sectional view of the TFT taken on the line Y-Y of Figure 1(A);

Figure 2 is a sectional view of a conventional TFT with a holding capacitor;

Figure 3 is a plan view of another conventional TFT of simplified construction but without a holding capacitor;

Figure 4 is an equivalent circuit diagram of a liquid crystal display device using a TFT array according to the present invention;

Figure 5 is a plan view on an enlarged scale of a holding capacitor of a TFT of a TFT array according to the present invention; and

Figures 6(A) to 6(D) are sectional views illustrating the steps of a method according to the present invention of manufacturing a TFT array.

In order to solve the above-mentioned problems of known TFTs, TFTs of a given row of a TFT array according to the present invention are formed by utilising gate electrodes of neighbouring TFTs that have a holding capacitor. This enables a TFT having a holding capacitor to be easily fabricated and its method of manufacture simplified, whereby TFT of high quality can be manufactured with good yield.

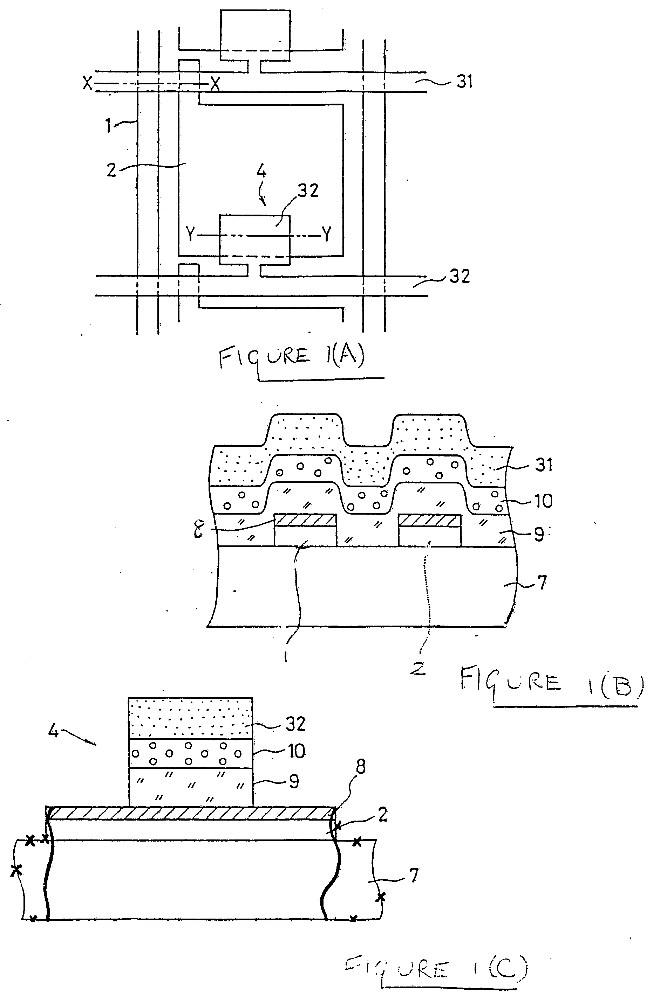

A thin film transistor array according to the present invention has a plurality of row electrodes, a plurality of column electrodes and a plurality of picture element electrodes. Referring now to Figures 1(A) to 1(C) there is shown one embodiment of one TFT of a TFT array according to the present invention. The TFT has a drain electrode 1, a source electrode 2, gate electrodes 31,32 and a holding capacitor 4. As seen in Figure 1(B) an electrically insulating substrate 7 is made of quartz, glass or the like. The drain and source electrodes 1,2 may be composed of indium-tin oxide (ITO). An n-type semi-conductor layer 8 permits the drain electrode 1 and the source electrode 2 to come into ohmic contact with a semi-conductor layer 9 located over them. The semi-conductor layer 8 is, for example, composed of hydrogenated amorphous silicon doped with phosphorus or fine crystalline silicon doped with phosphorus. The semi-conductor layer 9 is composed of hydrogenated amorphous silicon or fluorinated amorphous silicon. An insulating film 10 is composed of nitrogenated amorphous silicon or oxidised amorphous silicon. The gate electrodes 31,32 may be composed of a metal such as, for example, chromium, aluminium, molybdenum, tantalum or an alloy of any two or more thereof.

To drive a liquid crystal display device using a TFT array according to the present invention, each TFT is turned ON by a gate pulse applied to the gate electrode 32, and a signal is written from the drain electrode 1 during this period. The signal that is written is stored in the holding capacitor 4 as an electric charge. When the gate pulse is no longer supplied, the TFT is turned OFF, and the electric charge stored in the holding capacitor leaks through liquid crystal material of the liquid crystal display device before the application of the next gate pulse.

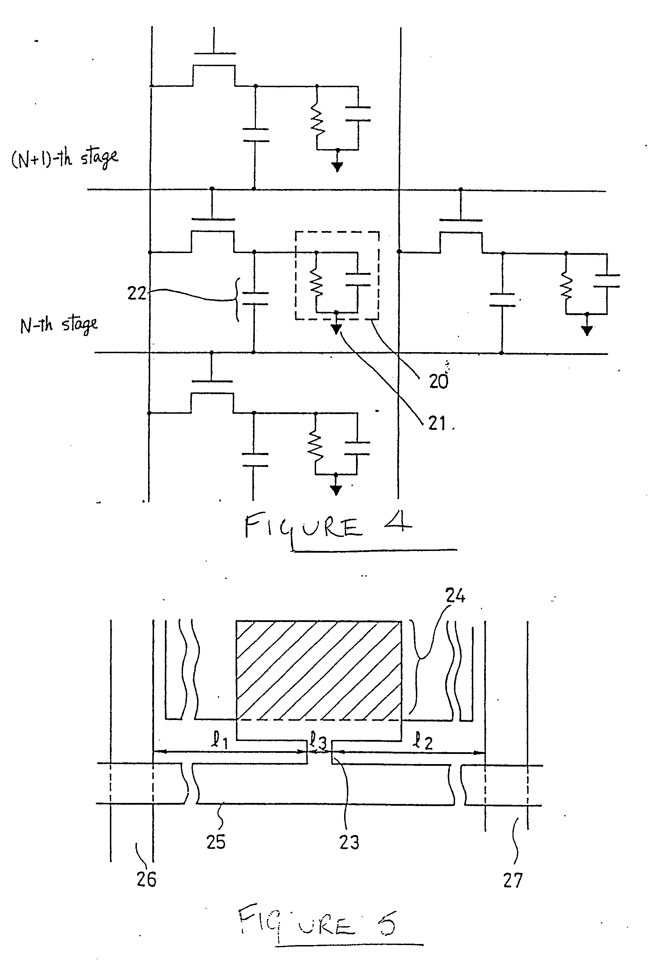

Figure 4 is an equivalent circuit diagram of a liquid crystal display device using a TFT array according to the present invention. The portion surrounded by a broken line 20 represents the equivalent circuit of a liquid crystal layer or cell. Arrow 21 indicates that one side of the liquid crystal layer is connected to a common potential. One terminal of a holding capacitor 22 of the TFT of the (N+1)th stage is connected to the gate electrode of the Nth stage, i.e. connected to the gate electrode of the preceding stage.

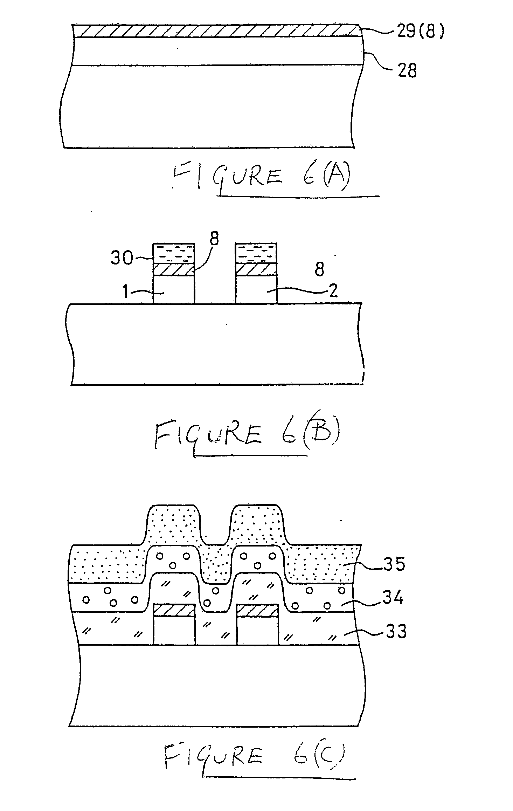

Figure 5 is a diagram illustrating the holding capacitor on an enlarged scale. The holding capacitor has a neck 23 and a capacitor unit 24. A signal applied to a drain electrode 26 or 27 may be written onto the holding capacitor through a channel in the case where a gate pulse enters into a gate electrode 25. To prevent this, it is desired that the neck 23 has a width $l_3$ as narrow as possible and is a long distance $l_1$ from the nearest drain electrode 26 and is a long distance $l_2$ from the nearest drain electrode 27. The area of the capacitor unit 24 is designed by calculating the writing ability of the TFT, resistance of the liquid crystal layer, resistance of the TFT when turned OFF, and the dielectric constant of the insulating film.

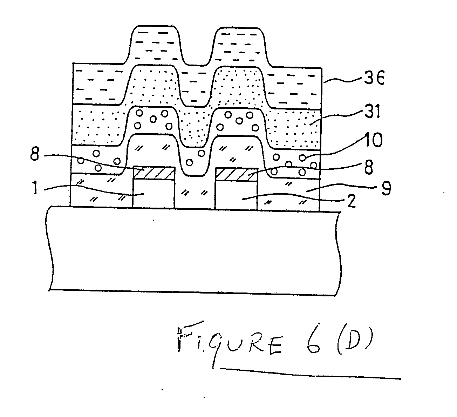

A method of manufacturing a TFT according to the present invention will now be described with reference to Figures 6(A) to 6(D). A transparent conductive film 28 is deposited on an insulating substrate by a sputtering or a vaporisation method. Then an n-type semi-conductor layer 29 is deposited thereon by a plasma CVD technique or by reactive sputtering (Figure 6(A)).

Then a photo-resist is applied onto the n-type semi-conductor layer followed by exposure and developing through a first photo-mask. The n-type semi-conductor layer and the transparent conductive layer are then selectively removed so that they will have the same pattern. Thus the source electrode 1 and the drain electrode 2 are formed (Figure 6(B)).

Thereafter a semi-conductor layer 33, an insulating film 34 and a conductive film 35 are deposited on the n-type semi-conductor layer 29 and the insulating substrate by a plasma CVD technique, reactive sputtering, sputtering, a vaporisation method or the like (Figure 6(C)).

A photo-resist 36 is applied thereon followed by exposure and developing through a second photo-mask, and the three layers deposited in the step illustrated in Figure 6(C) are selectively removed such that they will have the same pattern (Figure 6(D)). In this case, the conductive film 35 also serves as part of the gate electrode 31 and the holding capacitor 4.

The TFT array according to the present invention described above utilises TFTs whose gate electrode and one of the electrodes of the holding capacitor are common and have the same laminated construction in cross-section. Furthermore the holding capacitor has an electrode common to a separate gate electrode, the electrode being formed on the source electrode such that these electrodes pass on the source electrode. Therefore there is no need to increase the steps necessary to form the holding capacitor.

The TFT array according to the present invention and described above can be manufactured using on two photo-processing steps. This has the advantage of not only increasing manufacturing yield and reducing manufacturing cost but also does not cause loss of picture quality due to the holding capacitors unlike conventional TFT arrays having simplified construction when used in liquid crystal display devices.

**Claims**

1. A thin film transistor array for an electro-optical device characterised by comprising a plurality of row electrodes, a plurality of column electrodes, and a plurality of picture element electrodes, each of the picture element electrodes and one of the row and column electrodes operating as source (2) or drain electrodes (1, 26, 27) and having a n-type semi-conductor layer (8) thereon and connecting to each other through a semi-conductor layer (9) provided on the n-type semi-conductor layer (8), the other of the row and column electrodes operating as gate electrodes (31, 32) provided on the semi-conductor layer (9) through an insulating layer (10), the gate electrodes and the corresponding source and drain electrodes constituting switching transistors, and the gate electrodes and neighbouring picture element electrodes having overlapping portions which operate as holding capacitors (4, 22).

2. A thin film transistor array as claimed in claim 1 characterised in that the picture element electrodes and one of the column and row electrodes are made of the same material.

3. A thin film transistor array as claimed in claim 2 characterised in that said same material is indium-tin oxide.

4. A thin film transistor array as claimed in any preceding claim characterised in that the n-type semi-conductor layer (8) is composed of hydrogenated amorphous silicon doped with phosphorus or fine crystalline silicon doped with phosphorus.

5. A thin film transistor array as claimed in any preceding claim characterised in that the semi-conductor layer (9) is composed of hydrogenated amorphous silicon or fluorinated amorphous silicon.

6. A thin film transistor array as claimed in any preceding claim characterised in that the insulating layer (10) is composed of nitrogenated amorphous silicon or oxidised amorphous silicon.

7. A thin film transistor array as claimed in any preceding claim characterised in that one terminal of the capacitor of the TFT is connected to the gate electrode of the preceding stage.

8. A thin film transistor array as claimed in any preceding claim characterised in that the holding capacitors (22) are connected to the drain electrodes (26,27) through narrow necks (23).

9. A method of manufacturing a thin film transistor array for an electro-optical device characterised by comprising: successively depositing a transparent conductive film (28) and an n-type semi-conductor layer (29) on an insulating substrate; applying a photo-resist onto said n-type semi-conductor layer (29) followed by the exposure and developing through a first photo-mask, and then selectively removing said n-type semi-conductor layer (29) and said transparent conductive film (28); successively depositing a semi-conductor layer (33), an insulating film (34) and a conductive film (35) on said n-type semi-conductor layer (29) and said insulating substrate; and applying a photo-resist onto said conductive film (35) followed by exposure and developing through a second photo-mask, and then selectively removing said conductive film (35), said insulating film (34) and said semi-conductor layer (33).

FIGURE 1(A)

FIGURE 1(B)

FIGURE 1(C)

19

FIGURE 2

18

15

17

16

12

13

14

FIGURE 3

FIGURE 4

FIGURE 5

FIGURE 6(A)

FIGURE 6(B)

FIGURE 6(C)

FiGURE 6 (D)